**Europäisches Patentamt**

**European Patent Office**

**Office européen des brevets**

(19)

(11)  **EP 0 935 344 A2**

(12)  **EUROPÄISCHE PATENTANMELDUNG**

(43) Veröffentlichungstag:
    **11.08.1999 Patentblatt 1999/32**

(51) Int. Cl.[6]: **H03K 17/0814**

(21) Anmeldenummer: **99102064.5**

(22) Anmeldetag: **29.01.1999**

(84) Benannte Vertragsstaaten:
    **AT BE CH CY DE DK ES FI FR GB GR IE IT LI LU
    MC NL PT SE**
    Benannte Erstreckungsstaaten:
    **AL LT LV MK RO SI**

(30) Priorität: **09.02.1998 DE 19805141**

(71) Anmelder:
    **SIEMENS AKTIENGESELLSCHAFT
    80333 München (DE)**

(72) Erfinder:
    • **Bakran, Mark-Matthias, Dr.
      91074 Herzogenaurach (DE)**
    • **Teigelkötter, Johannes, Dr.
      91074 Herzogenaurach (DE)**

(54)  **Schaltentlastungsanordnung**

(57)  Die Erfindung bezieht sich auf eine unsymmetrische Schaltentlastungsanordnung (SC) für eine zwischen zwei Polen (+, -) einer Gleichspannungsquelle angeordneten Reihenschaltung zweier in gleicher Richtung gepolter, gategesteuerter Leistungshalbleiterschalter (V1, V2), denen jeweils eine Freilaufdiode (V3, V4) antiparallel geschaltet ist, wobei diese unsymmetrische Schutzbeschaltung (SC) einen Speicherkondensator ($C_S$), einen Abschaltentlastungskondensator ($C_B$) und zwei Abschaltentlastungsdioden (V5, V6) aufweist, die elektrisch in Reihe geschaltet sind. Erfindungsgemäß ist diesen elektrisch in Reihe geschalteten Abschaltentlastungsdioden (V5, V6) eine Entlastungsdiode (V7) elektrisch parallel geschaltet. Somit werden die Verluste der beiden Abschaltentlastungsdioden (V5, V6) erheblich reduziert, so daß diese Reihenschaltung der beiden Leistungshalbleiterschalter (V1, V2) an eine höhere Gleichspannung mit höherer Schaltfrequenz betrieben werden kann.

FIG 6

EP 0 935 344 A2

**Beschreibung**

Die Erfindung bezieht sich auf eine Schaltentlastungsanordnung gemäß dem Oberbegriff des Anspruchs 1 bzw. 2. Eine Schaltentlastungsanordnung gemäß Oberbegriff des Anspruchs 2 ist in dem deutschen Patent 32 44 623 angegeben.

Unter gategesteuerten Leistungshalbleiterschaltern sind GTO-Thyristoren, aber auch alle sonstigen über ihren Steueranschluß ein- und abschaltbare Halbleiterschaltelemente zu verstehen.

Damit die Leistungshalbleiterschalter von Wechselrichtern großer Leistung durch allzu großen Stromanstieg (di/dt) bzw. Spannungsanstieg (du/dt) nicht zerstört werden, müssen sie durch eine Beschaltung (Snubber) geschützt werden. Außerdem muß die Beschaltung so ausgelegt sein, daß für die Leistungshalbleiterschalter eine kleine Ein-/Ausschaltdauer erreicht wird und die Leistungshalbleiterschalter beim Ausschalten mit möglichst wenig Spitzenspannung beansprucht werden.

Fortschritte in der Halbleitertechnik ermöglichen nun höhere Spannungen und Schaltfrequenzen von gategesteuerten Leistungshalbleiterschaltern und deren zugehörigen Freilaufdioden. Dabei steigt die Beanspruchung der Schutzbeschaltung mit zunehmender Spannung und Schaltfrequenz stark an. Insbesondere steigen die Verluste in den Abschaltentlastungsdioden der Schutzbeschaltung an. Deshalb kann die Sperrschichttemperatur der Abschaltentlastungsdioden die Schaltfrequenz und/oder die Zwischenkreisspannung des Stromrichters begrenzen, da die Kühlung der Abschaltentlastungsdioden meist aus wirtschaftlichen Gründen weniger intensiv als bei den gategesteuerten Leistungshalbleiterschaltern und den Freilaufdioden ist.

Die aus dem deutschen Patent 32 44 623 bekannte unsymmetrische Schaltentlastungsanordnung kann vorteilhaft beim Betrieb von gategesteuerten Leistungshalbleiterschaltern mit hoher Spannung eingesetzt werden. Die Abschaltentlastungsdioden werden durch Ausgleichsvorgänge beim Einschalten und Ausschalten eines gategesteuerten Leistungshalbleiterschalters belastet. Beim Einschalten eines gategesteuerten Leistungshalbleiterschalters muß der Abschaltentlastungskondensator umgeladen und beim Ausschalten muß die Drosselspule ummagnetisiert werden. Diese Ausgleichsvorgänge verursachen Ströme in den Abschaltentlastungsdioden, deren Amplituden beim Einschalten proportional zur Zwischenkreisspannung und beim Ausschalten proportional zum Laststrom sind. Der Effektivwert dieser Ströme steigt proportional mit der Wurzel aus der Schaltfrequenz an.

Der Erfindung liegt nun die Aufgabe zugrunde, diese bekannte Schaltentlastungsanordnung derart weiterzubilden, daß die Verluste der Abschaltentlastungsdioden verringert werden.

Diese Aufgabe wird erfindungsgemäß dadurch gelöst, daß den elektrisch in Reihe geschalteten Abschaltentlastungsdioden eine Entlastungsdiode elektrisch parallelgeschaltet ist.

Durch diese zusätzliche Entlastungsdiode wird grundsätzlich die Schutzfunktion für die gategesteuerten Leistungshalbleiterschalter und deren Freilaufdioden nicht beeinflußt. Lediglich die Leitdauer und damit die Verluste in den Abschaltentlastungsdioden werden erheblich reduziert. Mittels der Entlastungsdiode wird eine neue Stromaufteilung erreicht, die zur Verringerung der Verlustleistung in den Abschaltentlastungsdioden führt.

Durch die Reduzierung der Verluste in den Abschaltentlastungdioden der Schutzbeschaltung können Dioden mit einer kleineren Abmessung verwendet werden, wodurch diese Abschaltentlastungsdioden näher an die gategesteuerten Leistungshalbleiterschalter angeordnet werden können. Dadurch werden ebenfalls die Streuinduktivitäten reduziert.

Werden keine räumlich kleineren Abschaltentlastungsdioden verwendet, so kann die Reihenschaltung zweier in gleicher Richtung gepolter, gategesteuerter Leistungshalbleiterschalter an eine höhere Gleichspannung mit einer höheren Schaltfrequenz betrieben werden. Somit kann man durch Hinzufügen einer weiteren Diode in einer Schutzbeschaltung eines Phasenbausteins einer Stromrichterschaltung diesen Phasenbaustein ohne Abänderung des Gehäuses bei einer höheren Leistung verwenden.

Diese erfindungsgemäße Schaltentlastungsanordnung kann auch bei einem Dreipunkt-Wechselrichter-Zweig angewendet werden. Ein derartiger Dreipunkt-Wechselrichter-Zweig besteht aus zwei aneinander geschalteten Stromrichter-Zweigen gemäß den Ansprüchen 1 und 2. Die Zusammenlegung von zwei Verbindungspunkten der beiden Stromrichter-Zweige ergibt einen Wechselspannungsanschluß des Dreipunkt-Wechselrichter-Zweiges. Außerdem sind die Speicherkondensatoren anstelle mit einem Verbindungspunkt miteinander verbunden, wobei dieser Verbindungspunkt jeweils mittels einer Entkoppeldiode mit einer direkten Verbindung der beiden oberen und unteren Leistungshalbleiterschalter verknüpft ist.

Zur näheren Erläuterung der Erfindung wird auf die Zeichnung Bezug genommen, in der eine Ausführungsform der erfindungsgemäßen Schaltentlastungsanordnung schematisch veranschaulicht ist.

| FIG 1 | zeigt eine bekannte Schaltentlastungsanordnung eines Zweipunkt-Stromrichterzweiges, in den |
| FIG 2 und 3 | sind jeweils in einem Diagramm über der Zeit t die Stromverläufe in den Abschaltentlastungsdioden beim Ausschalten eines Leistungshalbleiterschalters dargestellt, wogegen in den |
| FIG 4 und 5 | jeweils in einem Diagramm über der Zeit t die Stromverläufe in den Anschaltentlastungsdioden beim |

Einschalten eines Leistungshalbleiterschalters veranschaulicht sind, die

FIG 6       zeigt eine erfindungsgemäße Schaltentlastungsanordnung, wogegen in der

FIG 7       eine Variante dieser erfindungsgemäßen Schaltentlastungsanordnung dargestellt ist, die

FIG 8 und 9     zeigen jeweils in einem Diagramm über der Zeit t die Stromverläufe in einer Abschaltentlastungs- und der Entlastungsdiode beim Ausschalten eines Leistungshalbleiterschalters, wogegen in den

FIG 10 und 11   jeweils in einem Diagramm über der Zeit t die Stromverläufe in einer Abschaltentlastungs- und der Entlastungsdiode dargestellt sind, die

FIG 12      zeigt eine Schaltentlastungsanordnung nach FIG 6 mit den zugehörigen parasitären Induktivitäten, in den

FIG 13 und 14   sind jeweils in einem Diagramm über der Zeit t die Kommutierungen von einer Abschaltentlastungsdiode auf die Entlastungsdiode beim Ausschalten eines Leistungshalbleiterschalters dargestellt, wogegen in den

FIG 15 und 16   jeweils in einem Diagramm über die Zeit t die Kommutierungen beim Einschalten veranschaulicht sind und die

FIG 17      zeigt einen Dreipunkt-Wechselrichter-Zweig mit der erfindungsgemäßen Schaltentlastungsanordnung.

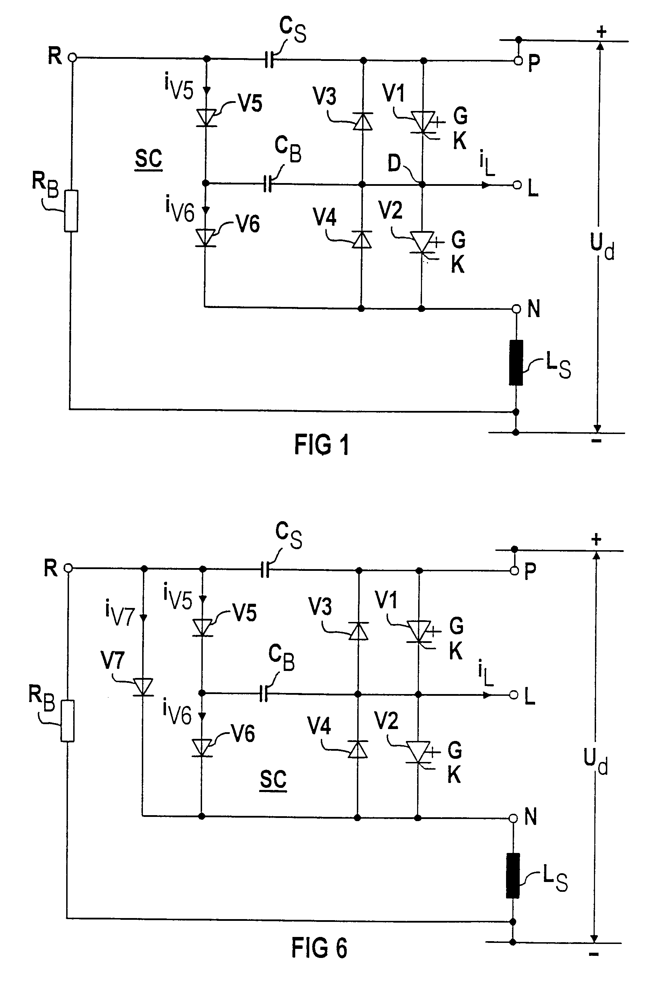

In der FIG 1 ist eine bekannte Schaltentlastungsanordnung SC für eine zwischen zwei Polen + und - einer Gleichspannungsquelle angeordneten Reihenschaltung zweier in gleicher Richtung gepolter, gategesteuerter Leistungshalbleiterschalter V1 und V2 dargestellt. Als Gleichspannungsquelle dient beispielsweise ein Zwischenkreiskondensator, an dem eine Zwischenkreisspannung $U_d$ anliegt. Aus Übersichtlichkeitsgründen ist diese Spannungsquelle nicht näher dargestellt. Die Schaltentlastungsanordnung SC, die auch als unsymmetrische Schutzbeschaltung SC bezeichnet wird, ist indirekt aus der eingangs genannten deutschen Patentschrift bekannt. Diese Schaltentlastungsanordnung SC weist zwei Abschaltentlastungsdioden V5 und V6, einen Abschaltentlastungskondensator $C_B$, einen Speicherkondensator $C_S$ und einen Beschaltungswiderstand $R_B$ auf. Außerdem ist die Reihenschaltung der beiden Leistungshalbleiterschalter V1 und V2 mit einer Drosselspule $L_S$ versehen, die den Anstieg des Einschaltstromes begrenzt. Diese Drosselspule $L_S$ verbindet den negativen Anschlußpunkt N der Reihenschaltung dieser beiden Leistungshalbleiterschalter V1 und V2 mit dem negativen Pol - der Gleichspannungsquelle. Die direkte Verbindung D der beiden Leistungshalbleiterschalter V1 und V2 bilden einen Wechselspannungsanschluß L. Der positive Anschluß P der Reihenschaltung der beiden Leistungshalbleiterschalter V1 und V2 ist direkt mit dem positiven Pol + der Gleichspannungsquelle verbunden. Jedem Leistungshalbleiterschalter V1 bzw. V2 ist antiparallel eine Freilaufdiode V3 bzw. V4 elektrisch parallel geschaltet.

Der Abschaltentlastungskondensator $C_B$ verbindet mittels der zweiten Abschaltentlastungsdiode V6 die Verbindung D mit dem negativen Anschluß N der Reihenschaltung der beiden Leistungshalbleiterschalter V1 und V2. Der positive Anschluß P dieser Reihenschaltung ist mittels des Speicherkondensators $C_S$ und der ersten Abschaltentlastungsdiode V5 mit dem Verbindungspunkt von Abschaltentlastungskondensator $C_B$ und -diode V6 verknüpft. Ein Verbindungspunkt R von Speicherkondensator $C_S$ und erster Abschaltentlastungsdiode V5 ist mittels des Beschaltungswiderstandes $R_B$ mit dem negativen Pol - der Gleichspannungsquelle verbunden.

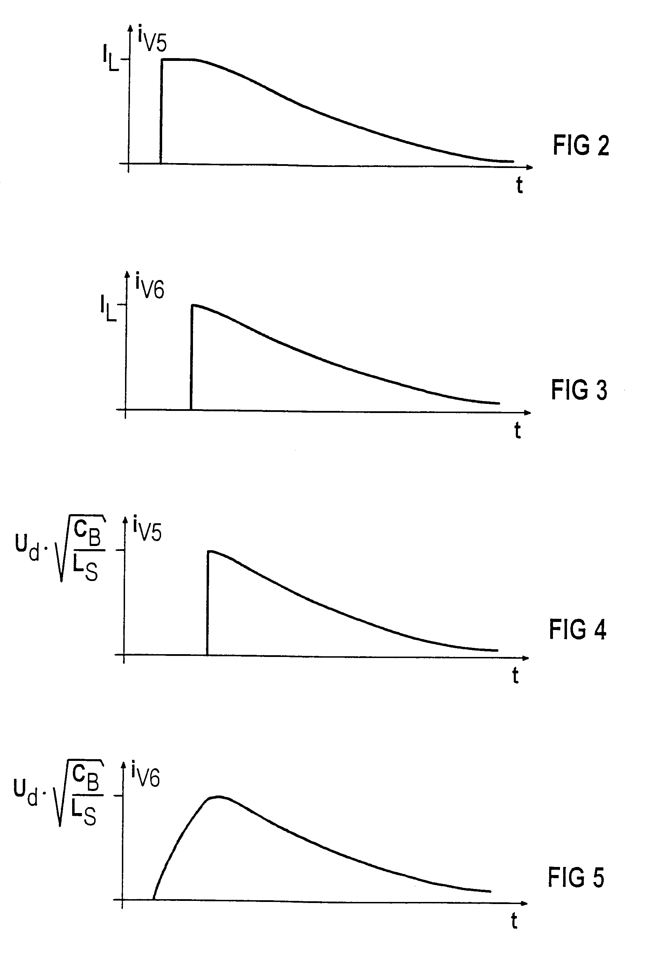

Anhand der Signalverläufe der FIG 2 bis 5 soll die Funktionsweise dieser Schaltentlastungsanordnung SC beim Ausschalten des Leistungshalbleiterschalters V1 und bei seinem Einschalten näher erläutert werden:

Zu Beginn des Ausschaltvorgangs des Leistungshalbleiterschalters V1 sind der Speicher- und der Abschaltentlastungskondensator $C_S$ und $C_B$ auf die Zwischenkreisspannung $U_d$ aufgeladen. Wird der Leistungshalbleiterschalter V1 ausgeschaltet, kommutiert der Laststrom $i_L$ vom Leistungshalbleiterschalter V1 auf die Abschaltentlastungsdiode V5 und entlädt den Abschaltentlastungskondensator $C_B$ (FIG 2). Sobald dieser Abschaltentlastungskondensator $C_B$ entladen ist, fließt der Strom durch die Abschaltentlastungsdiode V5 ebenfalls durch die Abschaltentlastungsdiode V6 und der Freilaufdiode V4 (FIG 4). Mit dem Stromfluß durch die Freilaufdiode V4 wird die Drosselspule $L_S$ aufmagnetisiert. In Abhängigkeit dieser Aufmagnetisierung der Drosselspule $L_S$ wird der Stromfluß durch die beiden Abschaltentlastungsdioden V5 und V6 abgebaut (FIG 2 und 3).

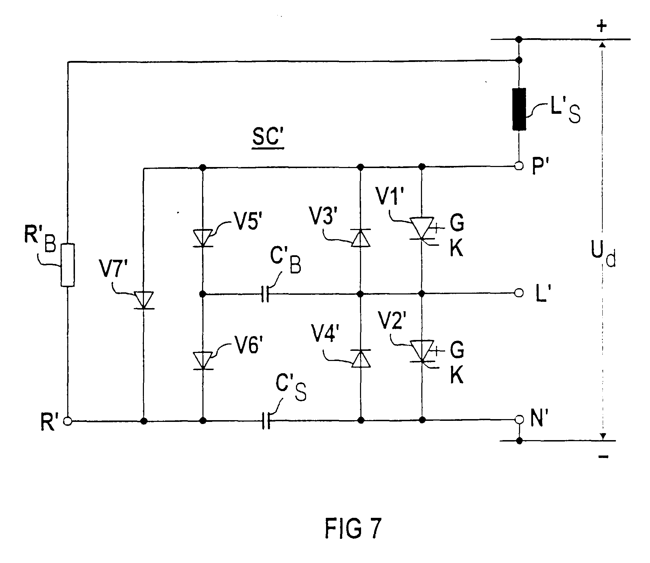

Zu Beginn des Einschaltvorgangs des Leistungshalbleiterschalters V1 sind der Abschaltentlastungskondensator $C_B$ entladen, der Speicherkondensator $C_S$ auf die Zwischenkreisspannung $U_d$ aufgeladen und die Drosselspule $L_S$ aufmagnetisiert. Beim Einschalten des Leistungshalbleiterschalters V1 wird dieser auf die leitende Freilaufdiode V4 geschaltet, wodurch der Abschaltentlastungskondensator $C_B$ mittels eines gebildeten Reihenschwingkreises aufgeladen wird. Dieser Reihenschwingkreis besteht aus der Drosselspule $L_S$ und dem Abschaltentlastungskondensator $C_B$. Dieser Umladestrom belastet die zweite Abschaltentlastungsdiode V6 (FIG 5). Erreicht die Spannung am Abschaltentlastungskondensator $C_B$ den Wert der Zwischenkreisspannung $U_d$, fließt der Umladestrom nun auch noch über die erste Abschaltentlastungsdiode V5 (FIG 4). Dieser Umladestrom durch die beiden Abschaltentlastungsdioden V5 und V6 baut sich mit der Zeit ab. Der Stromabbau ist von der Abmagnetisierung der Drosselspule $L_S$ abhängig, die wiederum mit Hilfe des Beschaltungswiderstandes $R_B$ bestimmt wird.

Bei dieser bekannten unsymmetrischen Schutzbeschaltung SC fließt der Strom während der Auf- bzw. Abmagnetisierung der Drosselspule $L_S$ über die Reihenschaltung der beiden Abschaltentlastungsdioden V5 und V6. Durch diesen Stromfluß entstehen in beiden Abschaltentlastungsdioden V5 und V6 Verluste. Da diese Abschaltentlastungsdioden V5 und V6 aus wirtschaftlichen Gründen nicht so intensiv gekühlt werden wie die Freilaufdioden V3 und V4, ist der maximale Wert der Zwischenkreisspannung $U_d$ oder der Schaltfrequenz von den abführbaren Verlusten dieser Abschaltentlastungsdioden V5 und V6 abhängig.

In der FIG 6 ist eine Schaltentlastungsanordnung SC gemäß der Erfindung dargestellt. Diese erfindungsgemäße Schaltentlastungsanordnung SC unterscheidet sich von der bekannten unsymmetrischen Schutzbeschaltung SC dadurch, daß elektrisch parallel zur Reihenschaltung der beiden Abschaltentlastungsdioden V5 und V6 eine Entlastungsdiode V7 geschaltet ist. Diese Entlastungsdiode V7 weist dieselbe Flußrichtung auf wie die beiden Abschaltentlastungsdioden V5 und V6.

In der FIG 7 ist eine Variante dieser erfindungsgemäßen Schaltungsentlastungsanordnung SC' dargestellt. Diese Schaltentlastungsanordnung SC' ohne die erfindungsgemäße Entlastungsdiode V7 ist aus dem eingangs genannten deutschen Patent 32 44 623, insbesondere der FIG 5, bekannt, so daß eine Beschreibung dieser Variante ohne die erfindungsgemäße Entlastungsdiode V7 sich erübrigt.

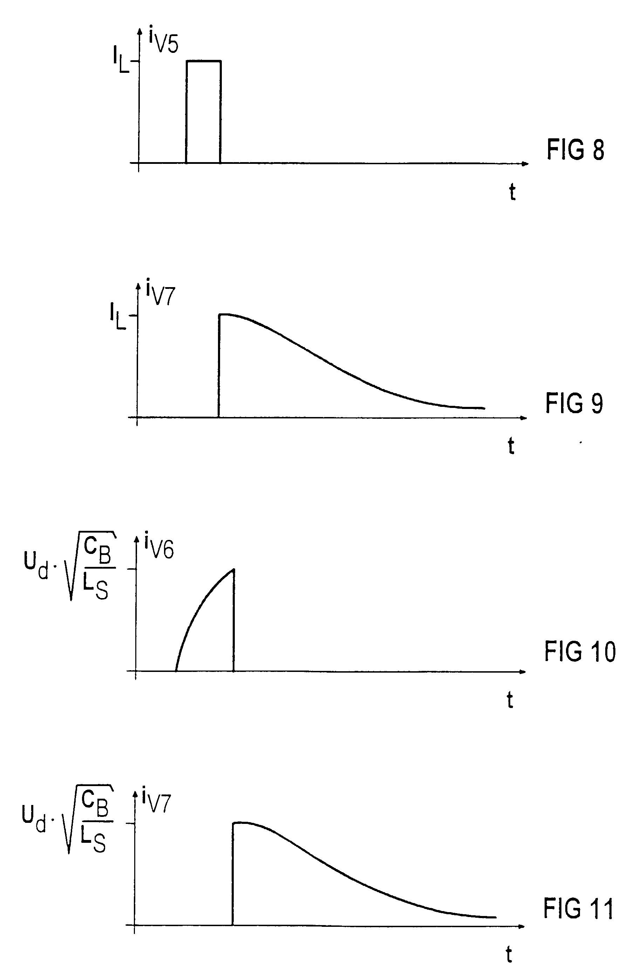

Anhand der Signalverläufe der FIG 8 bis 11 soll die Funktionsweise der erfindungsgemäßen Schaltentlastungsanordnung SC beim Ausschalten des Leistungshalbleiterschalters V1 und bei seinem Einschalten näher erläutert werden:

Auch hier sind zu Beginn des Ausschaltvorgangs des Leistungshalbleiterschalters V1 der Speicher- und der Abschaltentlastungskondensator $C_S$ und $C_B$ auf die Zwischenkreisspannung $U_d$ aufgeladen. Wird der Leistungshalbleiterschalter V1 ausgeschaltet, kommutiert der Laststrom $i_L$ vom Leistungshalbleiterschalter V1 auf die Abschaltentlastungsdiode V5 (FIG 8). Mittels diesem Stromfluß durch die Abschaltentlastungsdiode V5 wird der Abschaltentlastungskondensator $C_B$ entladen. Ist dieser Abschaltentlastungskondensator $C_B$ entladen, so übernimmt die Entlastungsdiode V7 den Strom der Abschaltentlastungsdiode V5 (FIG 9). Sobald die Entlastungsdiode V7 den Strom führt und über die Freilaufdiode V4 zum Wechselspannungsanschluß L fließt, wird die Drosselspule $L_S$ durch einen Laststrom durch die Drosselspule $L_S$ und der Freilaufdiode V4 aufmagnetisiert. In Abhängigkeit dieser Aufmagnetisierung der Drosselspule $L_S$ wird der Strom durch die Entlastungsdiode V7 abgebaut.

Zu Beginn des Einschaltvorgangs des Leistungshalbleiterschalters V1 sind der Abschaltentlastungskondensator $C_B$ entladen, der Speicherkondensator $C_S$ auf die Zwischenkreisspannung $U_d$ aufgeladen und die Drosselspule $L_S$ aufmagnetisiert (Endzustände nach dem Abschaltvorgang). Wird nun der Leistungshalbleiterschalter V1 eingeschaltet, so schaltet dieser auf die leitende Freilaufdiode V4. Dadurch entsteht ein Reihenschwingkreis, bestehend aus der Drosselspule $L_S$ und dem Abschaltentlastungskondensator $C_B$, der wieder aufgeladen wird. Dieser sogenannte Umladestrom belastet die zweite Abschaltentlastungsdiode V6 (FIG 10). Erreicht die Spannung am Abschaltentlastungskondensator $C_B$ den Wert der Zwischenkreisspannung $U_d$, so kommutiert der Umladestrom von der zweiten Abschaltentlastungsdiode V6 auf die Entlastungsdiode V7 (FIG 11). Der Strom durch die Entlastungsdiode V7 baut sich in Abhängigkeit der Abmagnetisierung der Drosselspule $L_S$ ab. Die Abnahmezeit dieses Stromes wird bestimmt durch die Drosselspule $L_S$, den Speicherkondensator $C_S$ und den Beschaltungswiderstand $R_B$.

Bei der bekannten unsymmetrischen Schutzbeschaltung SC werden beim Abschalten bzw. beim Einschalten des Leistungshalbleiterschalters V1 bzw. V2 immer beide Abschaltentlastungsdioden V5 und V6 belastet. D.h., der Strom während der Auf- bzw. Abmagnetisierung der Drosselspule $L_S$ fließt immer über die Reihenschaltung der beiden Abschaltentlastungsdioden V5 und V6 und verursacht damit höhere Gesamtverluste in diesen Abschaltentlastungsdioden V5 und V6.

Mit der erfindungsgemäßen Entlastungsdiode V7 fließt der Strom während der Auf- bzw. Abmagnetisierung der Drosselspule $L_S$ nur über diese Entlastungsdiode V7. Deshalb reduziert diese Entlastungsdiode V7 die Verluste der Abschaltentlastungsdioden V5 und V6.

Bei der bisherigen Betrachtung der bekannten und der erfindungsgemäßen Schaltentlastungsanordnung SC wurden alle parasitären Induktivitäten vernachlässigt.

Für die Beanspruchung des Leistungshalbleiterschalters V1 bzw. V2 während eines Abschaltvorgangs sind die parasitären Induktivitäten $L_{\sigma5}$ und $L_{\sigma6}$ bestimmend. Diese parasitären Induktivitäten $L_{\sigma5}$ und $L_{\sigma6}$ müssen durch geschickte Leitungsführung und einen kompakten Aufbau möglichst klein sein, um die Höhe der Vorwärts-Nadelspannung beim Ausschalten des Leistungshalbleiterschalters V1 bzw. V2 auf einem geringen Wert zu halten. Diese Nadelspannung tritt beim Verlauf der Anoden-Kathoden-Spannung am Leistungshalbleiterschalter V1 bzw. V2 beim Abschalten auf. Der Spannungsanstieg du/dt dieser Anoden-Kathoden-Spannung verläuft nicht linear, sondern weist am Anfang eine Zacke auf, die als Nadelspannung bezeichnet wird.

In der FIG 7 ist nun die Schaltentlastungsanordnung SC nach FIG 6 mit den parasitären Induktivitäten $L_{\sigma5}$, $L_{\sigma6}$ und $L_{\sigma7}$ dargestellt. Die parasitäre Induktivität $L_{\sigma7}$, die elektrisch in Reihe zur Entlastungsdiode V7 dargestellt ist, beeinflußt nicht die Nadelspannung am Leistungshalbleiterschalter V1 bzw. V2. Lediglich die Kommutierung des Stromes von der Abschaltentlastungsdiode V5 bzw. V6 auf die Entlastungsdiode V7 wird durch diese parasitäre Induktivität

$L_{\sigma7}$ beeinflußt.

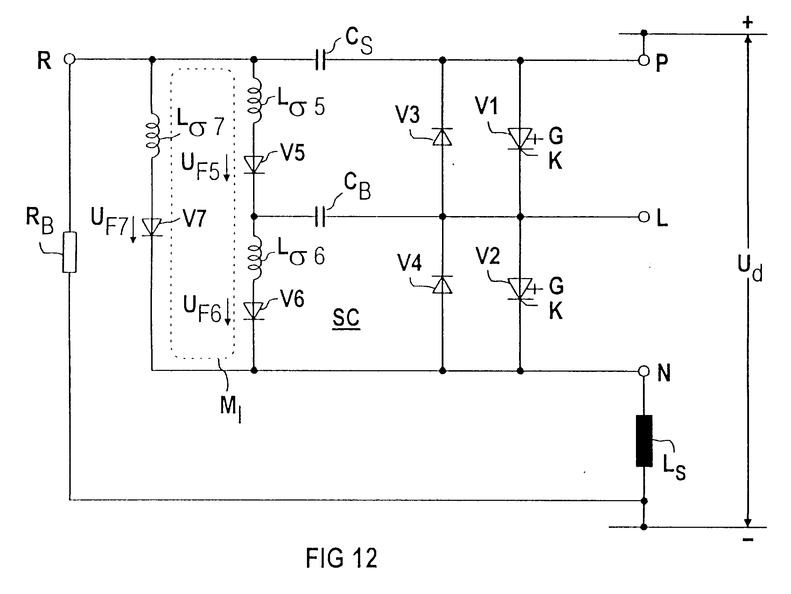

Da die parasitären Induktivitäten $L_{\sigma5}$ und $L_{\sigma6}$ vernachlässigbar klein gegenüber der parasitären Induktivität $L_{\sigma7}$ sind, genügt es zur Berechnung des Kominutierungsvorgangs, nur die parasitäre Induktivität $L_{\sigma7}$ zu berücksichtigen. Die treibende Spannung in der Kommutierungsmasche $M_I$, die in der FIG 12 mittels einer unterbrochenen Linie veranschaulicht ist, kann aus den Flußspannungen $U_{F5}$, $U_{F6}$ und $U_{F7}$ der drei Dioden V5, V6 und V7 dieser Masche $M_I$ berechnet werden. Diese treibende Spannung, die auch als Kommutierungsspannung $U_K$ bezeichnet wird, wird gemäß folgender Gleichung:

$$u_K = u_{F5} + u_{F6} - u_{F7}$$

berechnet.

Die Flußspannungen $u_F$ der Dioden V5, V6 und V7 sind in bekannter Weise durch eine Knickkennlinie beschreibbar, die durch folgende Gleichung:

$$u_F = U_O + r \cdot i$$

mit

$U_O$  = Knickspannung
$r$    = differentieller Widerstand

beschreibbar ist. Bei der Verwendung gleicher Dioden V5, V6 und V7 berechnet sich die Stromsteilheit zu Beginn der Kommutierung wie folgt:

$$\left.\frac{di}{dt}\right|_{Anfang} = \frac{U_0 + 2 \cdot r \cdot i_{Anfang}}{L_{\sigma7}} \qquad (1)$$

Beim Ausschalten eines Leistungshalbleiterschalters V1 bzw. V2 ist $i_{Anfang} = I_L$ und beim Einschalten eines Leistungshalbleiterschalters V1 bzw. V2 ist

$$i_{Anfang} = \sqrt{\frac{C_B}{L_S}} \cdot U_d$$

Vereinfachend kann der differentielle Widerstand r vernachlässigt werden, damit bestimmt sich die Anfangsstromsteilheit gemäß Gleichung (1) zu:

$$\left.\frac{di}{dt}\right|_{Anfang} \approx \frac{U_0}{L_{\sigma7}} \qquad (2)$$

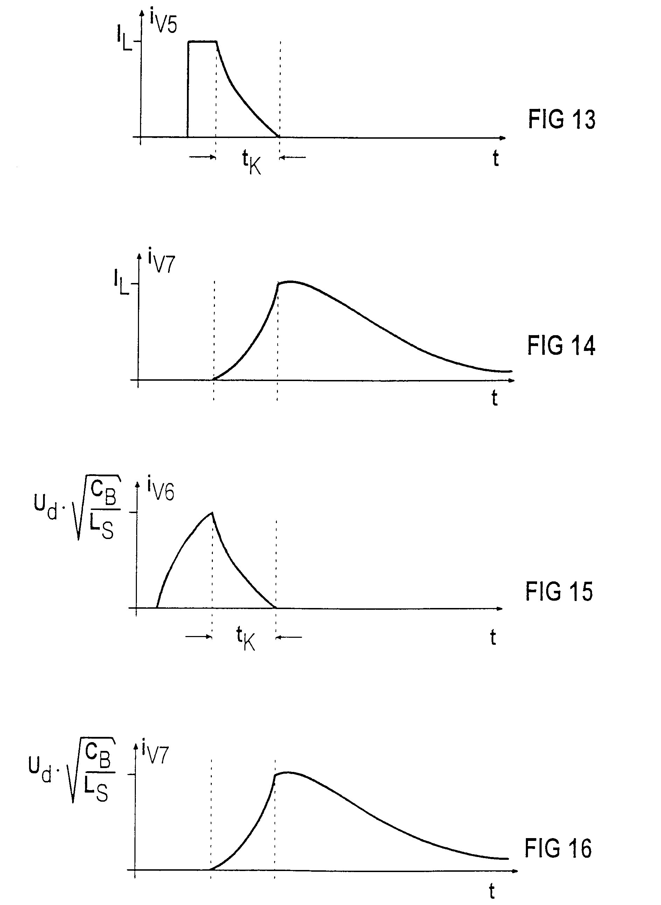

Mit der parasitären Induktivität $L_{\sigma7}$, die vorteilhaft als Leitungsinduktivität ausgeführt wird, kann die Stromsteilheit bei der Kommutierung eingestellt werden. Dieser Kommutierungsvorgang erfordert, wie in den FIG 13 bis 16 dargestellt, eine Überlappungszeit $t_K$, die mit dem Wert der parasitären Induktivität $L_{\sigma7}$ eingestellt werden kann.

Mit dieser Überlappungszeit $t_K$ läßt sich die Strombelastung der Entlastungsdiode V7 bzw. die Stromentlastung der Abschaltentlastungsdioden V5 und V6 beeinflussen. Dauert der Kommutierungsvorgang lange, werden die Abschaltentlastungsdioden V5 und V6 nur wenig entlastet. Zweckmäßigerweise wird die parasitäre Induktivität $L_{\sigma7}$ so bemessen, daß alle Dioden V5, V6 und V7 entsprechend ihren Kühlverhältnissen belastet werden.

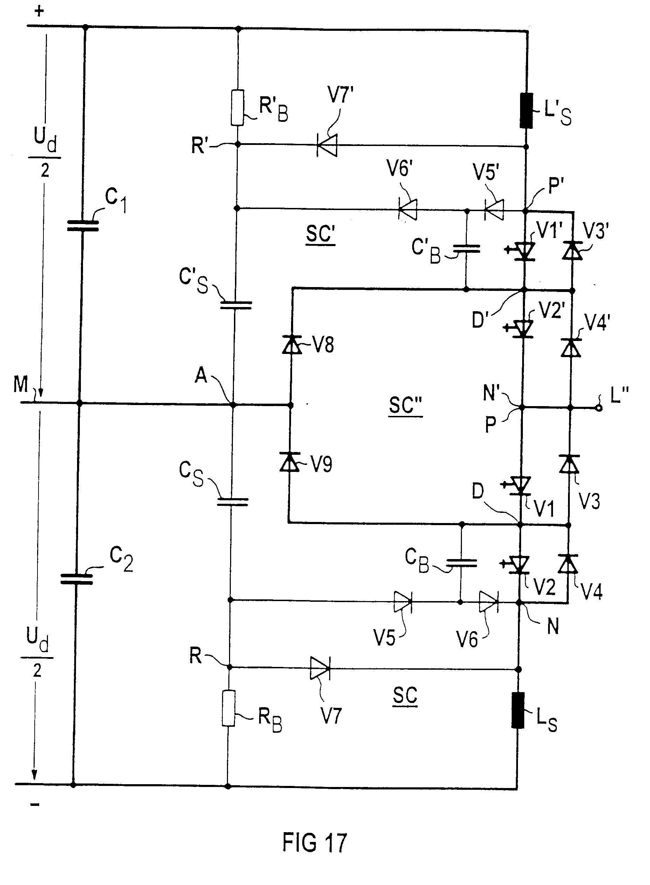

In der FIG 17 ist ein Dreipunkt-Wechselrichter-Zweig dargestellt, der zwischen zwei Polen + und - einer Gleichspannungsquelle, bestehend aus den Kondensatoren $C_1$ und $C_2$, vier in gleicher Richtung gepolter, gategesteuerter Leistungshalbleiterschalter V1', V2', V1 und V2 aufweist. Dieser Dreipunkt-Wechselrichter-Zweig ist aus den Zweipunkt-Zweigen gemäß den FIG 6 und 7 zusammengesetzt worden. Dabei bildet die Zweipunkt-Schaltung gemäß FIG 7 den oberen Teil des Dreipunkt-Wechselrichter-Zweiges, wogegen die Zweipunkt-Schaltung gemäß FIG 6 den unteren Teil dieses Dreipunkt-Wechselrichter-Zweiges bildet. Bei der Zusammenschaltung dieser beiden Schaltungen sind der negative Anschluß N' der Reihenschaltung der beiden Leistungshalbleiterschalter V1' und V2' mit dem positiven Ahschluß P der Reihenschaltung der beiden Leistungshalbleiterschalter V1 und V2 elektrisch leitend verbunden und bildet einen neuen Wechselspannungsanschluß L''. Außerdem sind jeweils die Verbindungen zwischen dem Speicherkondensator $C'_S$ und der Freilaufdiode V4' und zwischen dem Speicherkondensator $C_S$ und der Freilaufdiode V3 aufgetrennt und miteinander zu einem gemeinsamen Anschluß A verknüpft. Dieser gemeinsame Anschluß A ist einerseits mit einem Verbindungspunkt der beiden Kondensatoren C1 und C2 der Gleichspannungsquelle und andererseits jeweils mittels einer Entkopplungsdiode V8 bzw. V9 mit der direkten Verbindung D' bzw. D der beiden Leistungshalbleiterschalter V1' und V2' bzw. V1 und V2 verbunden. An der Schaltentlastungsanordnung SC' bzw. SC der elektrisch in Reihe geschalteten Leistungshalbleiterschalter V1' und V2' bzw. V1 und V2 wurde nichts geändert. Somit gelten die Vorteile der erfindungsgemäßen Schaltentlastungsanordnung SC und SC' gemäß den FIG 6 und 7 auch für die Schaltentlastungsanordnung SC'' für eine zwischen zwei Polen + und - einer Gleichspannungsquelle angeordneten Reihenschaltung von vier in gleicher Richtung gepolter, gategesteuerter Leistungshalbleiterschalter V1', V2', V1 und V2.

Mit dieser erfindungsgemäßen Entlastungsdiode V7 für eine bekannte unsymmetrische Schutzbeschaltung SC kann bei unveränderten Kühlverhältnissen und Abmessungen der Abschaltentlastungsdioden V 5 und V6 ein Phasenbaustein an eine höhere Gleichspannung mit höherer Schaltfrequenz betrieben werden. Der Einsatz dieser Entlastungsdiode V7 ist bei Hochspannungsstromrichtern im allgemeinen sehr viel preiswerter als eine Alternativlösung, die darin besteht, daß die Abschaltentlastungsdioden V5 und V6 leistungsmäßig vergrößert werden, wodurch ebenfalls ein größeres Gehäuse für einen Phasenbaustein mit verbesserter Kühlung dieser Abschaltentlastungsdioden V5 und V6 vorgesehen werden muß.

**Patentansprüche**

1.  Schaltentlastungsanordnung (SC) für eine zwischen zwei Polen (+, -) einer Gleichspannungsquelle angeordneten Reihenschaltung zweier in gleicher Richtung gepolter, gategesteuerter Leistungshalbleiterschalter (V1, V2) mit einer den Anstieg des Einschaltstromes begrenzenden Drosselspule ($L_S$), die zwischen dem zweiten Leistungshalbleiterschalter (V2) und dem negativen Pol (-) der Gleichspannungsquelle angeordnet ist, wobei jedem Leistungshalbleiterschalter (V1, V2) eine antiparallele Freilaufdiode (V3, V4) elektrisch parallelgeschaltet ist und ein Wechselspannungsanschluß (L) an der direkten Verbindung (D) der beiden Leistungshalbleiterschalter (V1, V2) liegt, wobei die Verbindung (D) mittels eines Abschaltentlastungskondensators ($C_B$) und einer zweiten Abschaltentlastungsdiode (V6) mit einem Verbindungspunkt (N) von zweitem Leistungshalbleiterschalter (V2) und Drossel ($L_S$) verbunden ist, wobei ein Verbindungspunkt (P) von erstem Leistungshalbleiterschalter (V1) und positivem Pol (+) mittels eines Speicherkondensators ($C_S$) und einer ersten Abschaltentlastungsdiode (V5) mit einem Verbindungspunkt von Abschaltentlastungskondensator ($C_B$) und -diode (V6) verbunden ist und wobei ein Verbindungspunkt (R) von Speicherkondensator ($C_S$) und erster Abschaltentlastungsdiode (V5) mittels eines Beschaltungswiderstandes ($R_B$) mit dem negativen Pol (-) der Gleichspannungsquelle verknüpft ist,
    **dadurch gekennzeichnet,**
    daß den elektrisch in Reihe geschalteten Abschaltentlastungsdioden (V5, V6) eine Entlastungsdiode (V7) elektrisch parallel geschaltet ist.

2.  Schaltentlastungsanordnung (SC') für eine zwischen zwei Polen (+, -) einer Gleichspannungsquelle angeordneten Reihenschaltung zweier in gleicher Richtung gepolter, gategesteuerter Leistungshalbleiterschalter (V1', V2') mit einer den Anstieg des Einschaltstromes begrenzenden Drosselspule ($L'_S$), die zwischen dem ersten Leistungshalbleiterschalter (V1') und dem positiven Pol (+) angeordnet ist, wobei jedem Leistungshalbleiterschalter (V1', V2') eine antiparallele Freilaufdiode (V3', V4') elektrisch parallelgeschaltet ist und ein Wechselspannungsanschluß (L') an der direkten Verbindung (D') der beiden Leistungshalbleiterschalter (V1', V2') liegt, wobei die Verbindung (D') mittels eines Abschaltentlastungskondensators ($C'_B$), einer zweiten Abschaltentlastungsdiode (V6') und eines Speicherkondensators ($C'_S$) mit einem Verbindungspunkt (N') von zweitem Leistungshalbleiterschalter (V2') und negativem Pol (-) verknüpft ist, wobei ein Verbindungspunkt (P') von erstem Leistungshalbleiterschalter (V1') und der Drosselspule ($L'_S$) mit einer ersten Abschaltentlastungsdiode (V5') mit einem Verbindungspunkt von Abschaltentlastungskondensator ($C'_B$) und -diode (V6') verbunden ist und wobei ein Verbindungspunkt (R') von Speicherkondensator ($C'_S$) und zweiter Abschaltentlastungsdiode (V6') mittels eines Beschaltungswiderstandes ($R'_B$) mit dem positiven Pol (+) der Gleichspannungsquelle verknüpft ist,
    **dadurch gekennzeichnet,**
    daß den elektrisch in Reihe geschalteten Abschaltentlastungsdioden (V5', V6') eine Entlastungsdiode (V7') elektrisch parallel geschaltet ist.

3. Schaltentlastungsanordnung (SC") für eine zwischen zwei Polen (+, -) einer Gleichspannungsquelle angeordneten Reihenschaltung von vier in gleicher Richtung gepolter, gategesteuerter Leistungshalbleiterschalter (V1', V2', V1, V2) nach Anspruch 2 und 1,
**dadurch gekennzeichnet**,
daß die Verbindungspunkte (N', P) einen gemeinsamen Wechselspannungsanschluß (L") bilden, daß die Speicherkondensatoren (C'$_S$, C$_S$) anstelle mit den Verbindungspunkten (N', P) miteinander verbunden sind und daß dieser Verbindungspunkt (A) jeweils mittels einer Entkopplungsdiode (V8, V9) mit dem Verbindungspunkt (D') der Leistungshalbleiterschalter (V1', V2') und mit dem Verbindungspunkt (D) der Leistungshalbleiterschalter (V1, V2) verknüpft ist.

FIG 1

FIG 6

FIG 2

FIG 3

FIG 4

FIG 5

FIG 7

FIG 8

FIG 9

FIG 10

FIG 11

FIG 12

EP 0 935 344 A2

$I_L$ — $i_{V5}$

$t_K$

t

**FIG 13**

$I_L$ — $i_{V7}$

t

**FIG 14**

$U_d \cdot \sqrt{\dfrac{C_B}{L_S}}$ — $i_{V6}$

$t_K$

t

**FIG 15**

$U_d \cdot \sqrt{\dfrac{C_B}{L_S}}$ — $i_{V7}$

t

**FIG 16**

FIG 17